# FASCICULE DE BREVET EUROPEEN

(11) **EP 2 606 454 B1**
(45) Date de publication et mention de la délivrance du brevet: **17.08.2016**
(21) Numéro de dépôt: 11727179.1
(22) Date de dépôt: 23.06.2011
(51) Int. Cl.: G06K 19/077, G06K 19/073

(54) **PROCÉDÉ DE FABRICATION D'UN DISPOSITIF ÉLECTRONIQUE COMPORTANT UN MODULE INDÉMONTABLE ET DISPOSITIF OBTENU**
VERFAHREN ZUR HERSTELLUNG EINER ELEKTRONISCHEN VORRICHTUNG MIT EINEM NICHT ENTFERNBAREN MODUL UND RESULTIERENDE VORRICHTUNG
METHOD FOR MANUFACTURING AN ELECTRONIC DEVICE COMPRISING A NON-REMOVABLE MODULE, AND RESULTING DEVICE

(30) Priorité: 17.08.2010 EP 10305894
(43) Date de publication de la demande: 26.06.2013
(73) Titulaire: Gemalto SA, 92190 Meudon (FR)
(72) Inventeur: DOSSETTO, Lucile, F-83270 Saint Cyr Sur Mer (FR); AUDOUARD, Laurent, F-13400 Aubagne (FR); LESUR, Jean-Luc, F-Bras 83149 (FR)
(74) Mandataire: Milharo, Emilien
(86) Numéro de dépôt international: PCT/EP2011/060585
(87) Numéro de publication internationale: WO 2012/022527

(56) Documents cités:
- EP-A1- 0 952 545
- WO-A1-98/06061
- WO-A2-01/39107
- DE-C1- 19 752 196
- FR-A1- 2 778 997
- GB-A- 2 055 508
- JP-A- 2001 014 442

## Description

Cette invention concerne un procédé de fabrication d'un dispositif électronique comprenant un module indémontable et le dispositif obtenu.

En particulier, l'invention vise un dispositif comportant un module électronique fixé dans une cavité de corps-support, ledit module comportant un film support ayant une métallisation sur une face supérieure et sur une face inférieure une puce de circuit intégré reliée à la métallisation à l'aide de fils électriques de raccordement à travers le film support, la puce de circuit intégré étant enrobée par au moins une matière d'enrobage et de protection mécanique.

Elle trouve application notamment dans les cartes à puce nécessitant de la sécurité au niveau du démontage du micromodule du corps de carte, que ce soit pour des utilisations bancaires, Identité ou autres. En effet, dans un contexte international de grande croissance de la sécurité et de l'authentification ainsi que de l'identité les fabricants de cartes à puces se doivent de proposer à leurs clients des cartes à puces dont il n'est pas possible d'arracher le micromodule sans le dégrader ou le détruire.

Le démontage du micromodule est déjà rendu impossible sans destruction de celui-ci par d'autres techniques telles que le collage structural ou également par ancrage mécanique de la puce et des fils électriques de connexion dans une résine solidaire du fond de cavité d'un corps de carte en plastique. Ainsi, lors d'un arrachage du module, la puce reste collée au fond de la cavité en étant déconnectée des plages de contact et désolidarisée du film support diélectrique.

Ce procédé a l'inconvénient de ne pas permettre le transport ou stockage aisé du module après connexion de la puce car les fils sont nus et peuvent être endommagés.

Le document WO 98/06061 A1 décrit un procédé d'encartage d'un module de carte à puce. Le procédé comprend une étape d'enrobage de la puce et de ses fils de connexion puis une étape d'insertion et collage du module dans une cavité de corps de carte.

L'invention a pour objectif de proposer un dispositif comportant un module électronique sur un support et qui soit doté d'une fonction anti-arrachement efficace qui ne présente pas l'inconvénient ci-dessus.

A cet effet, l'invention a pour objet un procédé de fabrication d'un dispositif électronique comprenant un module fixé dans une cavité d'un corps-support, ledit module comportant un film support ayant une métallisation du côté d'une face supérieure et du côté d'une face inférieure, une puce de circuit intégré reliée à la métallisation à l'aide de fils électriques de raccordement, la puce de circuit intégré étant enrobée par une matière d'enrobage et de protection mécanique ;

Le procédé se distingue en ce qu'il comprend une étape d'ancrage selon laquelle une seconde matière d'ancrage est prévue pour accrocher une portion d'au moins un desdits fils électriques et pour ancrer cette portion de fil au corps-support.

Ainsi une tentative de séparation du module du corps support engendre un sectionnement du fil au niveau de ladite portion.

Selon d'autres caractéristiques ou mode de mise en oeuvre du procédé :
- On effectue une étape d'enrobage de la puce par une première matière d'enrobage à l'exception de ladite portion de fil ;
- On effectue une étape d'enrobage de la puce par une première matière d'enrobage et une étape d'enlèvement partiel de matière d'enrobage autour desdites portions ce qui améliore la protection des fils jusqu'à l'encartage ;
- L'enlèvement de matière d'enrobage s'effectue par usinage laser ;
- L'enlèvement de matière d'enrobage forme une rainure ou évidement rejoignant au moins deux fils électriques et débouchant à la surface de la matière de protection ;
- Une quantité calibrée de matière d'ancrage est déposée au fond de la cavité avant report du module dans la cavité de manière à faire pénétrer la matière d'ancrage autour des portions de fil lors du report ;
- L'évidement est comblé par de la matière d'ancrage ;
- la matière d'ancrage est déposée sur la surface du module destinée à être encartée et au-dessus de la rainure, sous forme de film thermo-fusible à phase thermodurcissable, avant report du module dans la cavité.

L'invention a également pour objet le dispositif obtenu.

L'invention est décrite en relation avec des exemples illustrés sur les figures suivantes:
- La figure 1 illustre une étape du procédé de l'invention selon un premier mode de mise en oeuvre montrant la préparation d'un module ;
- La figure 2 illustre une autre étape du procédé de l'invention selon le premier mode de mise en oeuvre ;
- La figure 3 illustre le dispositif obtenu par le premier mode de mise en oeuvre du procédé de l'invention;
- La figure 4 illustre une étape du procédé de l'invention selon un second mode de mise en oeuvre montrant la préparation d'un module
- La figure 5 illustre une autre étape du procédé de l'invention selon le second mode de mise en oeuvre montrant l'usinage de rainure ;
- La figure 6 illustre une autre étape du procédé de l'invention selon le second mode de mise en oeuvre montrant le comblement des rainures ;
- La figure 7 illustre le dispositif obtenu par le second mode de mise en oeuvre du procédé de l'invention;
- La figure 8 illustre un arrachement du module en coupe longitudinale.

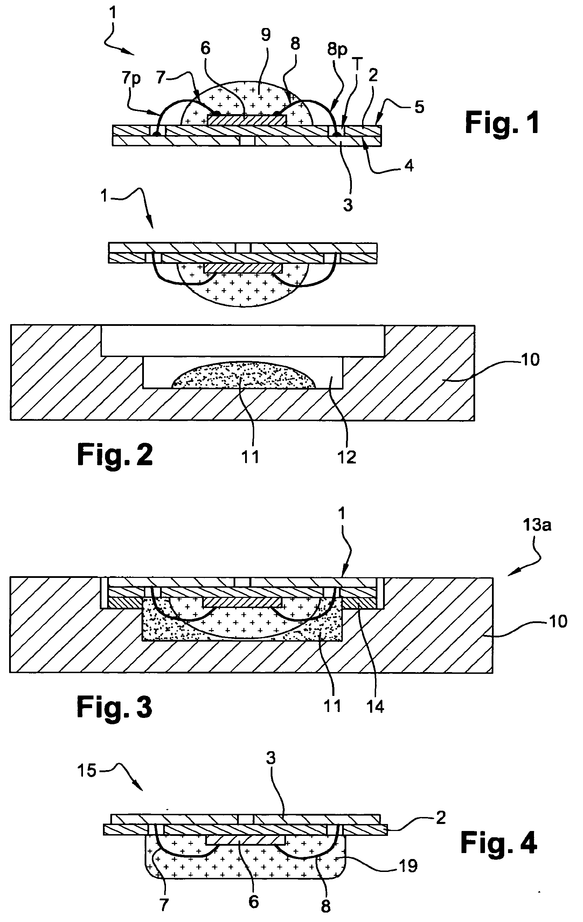

La figure 1 illustre une étape du procédé de fabrication d'un dispositif électronique de l'invention selon un premier mode de mise en oeuvre et concerne une préparation d'un module. Le dispositif final est visible en coupe longitudinale à la figure 3 ; il comprend un corps-support 10 muni d'une cavité 12 et un module 1 fixé dans la cavité.

Le module dans l'exemple est un module de carte à puce ; il comporte de manière classique un film support 2 ayant une métallisation 3 du côté d'une face supérieure 4 et du côté d'une face inférieure 5 une puce de circuit intégré 6 reliée à la métallisation à l'aide de fils électriques de raccordement 7, 8 (ou au moins un fil); les fils conducteurs traversent le film support isolant au niveau de perforations (T) pour accéder aux plages de contact. Le module comprend au moins une matière d'enrobage et de protection mécanique 9 recouvrant au moins la puce de circuit intégré. Ainsi, le module peut être manipulé, stocké jusqu'à son encartage. La résine d'enrobage recouvrant la puce, elle protège la face active de la puce et les plots de connexion de la puce orientée vers l'extérieur qui sont reliés aux fils de connexion.

La métallisation, est constituée dans l'exemple par des plages de contact électrique, notamment en cuivre, destinées à être connectées par un lecteur externe. La puce est reliée à la métallisation à travers le film. Ces plages peuvent être obtenues par lamination d'une couche métallique sur le diélectrique puis gravure chimique. Un motif quelconque métallique peut être réalisé selon différentes techniques connues de l'homme de l'art, par exemple par découpage mécanique ou par gravure chimique voire même par sérigraphie de matière conductrice. La métallisation peut être également une interface de communication sous forme d'antenne.

Selon une caractéristique de mise en oeuvre de l'invention, le procédé comprend une étape d'ancrage selon laquelle une matière d'ancrage (ou autre moyen d'ancrage : fil de couture, agrafe... en plus de la matière d'enrobage 9) est prévue pour accrocher une portion d'au moins un fil et pour ancrer cette portion de fil au corps support via la matière. L'ancrage est fait de manière qu'une tentative de séparation du module du corps support engendre un sectionnement d'au moins un fil au niveau de ladite portion.

Cette caractéristique ci-dessus peut être obtenue selon un premier mode de mise en oeuvre dans lequel on effectue au préalable un enrobage de la puce par une première matière d'enrobage à l'exception d'au moins une portion de fil électrique située du côté de la métallisation.

Dans l'exemple du premier mode, une goutte de résine d'enrobage de la puce est calibrée, dimensionnée et déposée de manière à ne pas couvrir au moins une portion de fil électrique 7, 8. Ainsi la résine ne couvre qu'une extrémité d'au moins un fil électrique soudée à un plot de la puce tandis que l'autre extrémité fixée à une métallisation n'est pas recouvert. La portion de fil 7p, 8p s'étendant de la métallisation à la surface de la résine est ainsi non recouverte et se trouve exposée à l'air libre.

A la figure 2, (coupe longitudinale du dispositif) on illustre l'opération d'encartage du module dans un corps support 10, en l'occurrence, un corps de carte à puce. Au préalable du report du module, on dépose une matière d'accrochage 11 au fond de la cavité 12 avant report du module dans la cavité. La matière d'accrochage est déposée en quantité calibrée de manière à entourer et accrocher les portions de fil 7p, 8p non enrobées, lors du report du module. La pression exercée sur le module lors de son report répartit la matière d'ancrage dans l'espace disponible de la cavité et autour de l'enrobage 9 de protection en remontant autour des portions de fils 7p, 8p.

A la figure 3, on voit en coupe longitudinale, que le dispositif électronique 13 obtenu de l'invention, se présente sous forme de carte à puce. La carte comprend de manière classique un module ou micromodule électronique 1 fixé sur le corps de carte 10, en particulier dans une cavité 12 ménagée dans le corps. La fixation peut utiliser un adhésif 14 notamment sous forme de couche ou film de type thermo-fusible ou thermo-adhésif communément appelé "hotmelt".

Les portions de fils 7p, 8p qui ne sont recouverts par la matière d'enrobage de la puce, sont cette fois recouvertes au moins en partie par la résine d'accrochage 11.

A la figure 4, les mêmes numéros qu'aux figures précédentes représentent les mêmes éléments ; Un second mode de mise en oeuvre du procédé commence par la préparation d'un module 15 d'une manière sensiblement différente. En effet, cette fois, un enrobage complet de la puce ainsi que des fils électriques 7, 8 par une matière d'enrobage 19.

Par la suite, selon un principe général de ce second mode, on procède à une étape d'enlèvement partiel de la matière d'enrobage 19 autour de portions de fils que l'on désire voir sectionner en cas de démontage du module. On peut viser toute portion de fil notamment une de leurs extrémités. Dans l'exemple, on retire la matière d'enrobage autour de portions de fils situées entre les extrémités des fils. On crée des évidements ou rainures ici linéaires (ou alternativement non linéaires) dans la matière ; Ces rainures sont traversées par des portions de fil électrique. Les rainures s'étendent d'un bord transversal de la résine jusqu'à un bord opposé comme une ouverture de tranchée dans la résine notamment jusqu'au film support. Les rainurent s'étendent de préférence à travers au moins deux fils électriques et débouchent à la surface de la matière de d'enrobage. Les deux rainures découpent l'enrobage ici en trois portions d'enrobage A, B, C. Les rainures peuvent ne pas déboucher sur les bords latéraux de l'enrobage de manière à former une cuvette pour un adhésif ultérieur.

L'étape d'enlèvement de matière d'enrobage s'effectue ici par usinage laser. Par exemple on utilise un laser CO2 d'une puissance de 100W; Toutefois, tout autre moyen peut être utilisé comme attaque chimique.

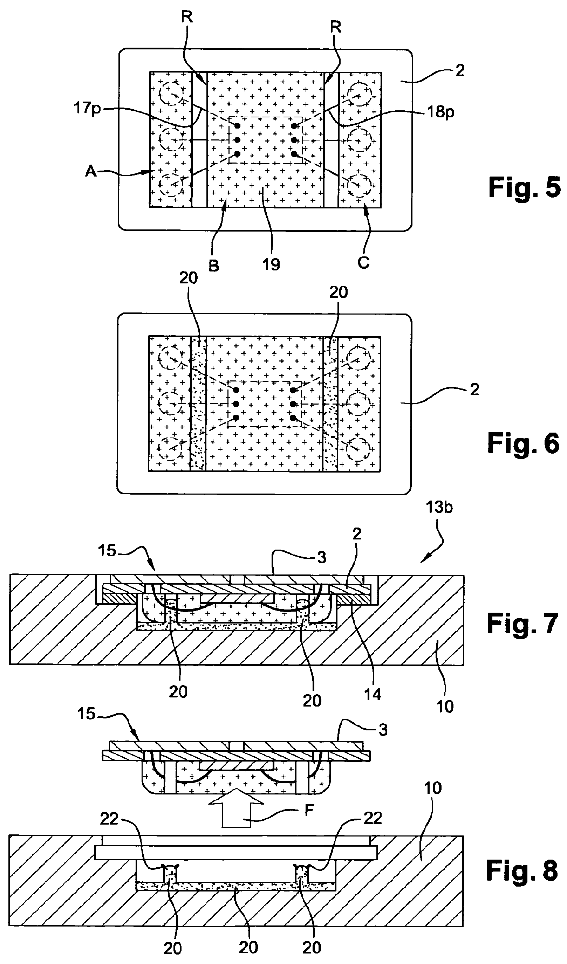

A la figure 6, le procédé comporte une étape de remplissage des rainures (ou évidement) par un adhésif d'accrochage des fils. Cet adhésif est choisi de manière à avoir une meilleure adhésion avec le corps support qu'avec la résine d'enrobage de la puce. On peut choisir par exemple de la colle cyanoacrylate.

Lors du report du module dans la cavité de manière classique, l'adhésif, encore visqueux de préférence, va fluer contre la surface du corps de carte à l'intérieur de la cavité. La viscosité ou forme de la rainure sont adaptées de manière que l'adhésif demeure dans la rainure après sa délivrance. S'il est visqueux, son niveau va un peu baisser au niveau du film support 2 par gravité lorsqu'il est retourné pour l'encartage. Lorsqu'il n'est plus visqueux on peut, le cas échéant, aussi ajouter une goutte d'adhésif d'ancrage au fond de la cavité pour adhérer à la matière d'ancrage ayant préalablement rempli les rainures.

Dans une autre variante, la matière d'ancrage (20) est déposée sous forme de film thermo-fusible (hotmelt) sur la surface du module destinée à être encartée et au-dessus de la rainure avant report du module dans la cavité. Ainsi, le film « hotmelt » sert autant d'adhésif d'encartage du module comme le film 14 que d'adhésif d'ancrage des portions de fil électrique.

Le film « hotmelt » est de préférence de type phénolique à fort pouvoir de fluage ; de préférence, il comporte une phase thermodurcissable pour éviter de le faire fondre à nouveau et ainsi démonter le module.

Alternativement, il est possible de faire en sorte que la matière d'ancrage n'adhère pas à la matière d'enrobage grâce notamment à un traitement de surface de la rainure par un dépôt anti-adhérent ou une forme évasée de la rainure vers l'extérieur.

La figure 8 illustre (en coupe longitudinale comme les précédentes), un arrachement du module exercé par une force F. L'arrachement provoque un sectionnement 22 de chaque portion de fil passant dans la rainure et qui était entourée par l'adhésif d'ancrage. L'adhésif d'ancrage accroche les portions de fils dans les rainures et les maintient dans la cavité grâce au pouvoir d'adhésion de la matière adhésive vis à vis du corps support.

Un résultat similaire se produit pour le premier mode de réalisation. Cependant, le sectionnement des fils va s'effectuer à l'interface de la résine d'enrobage avec la résine d'accrochage qui demeure dans la cavité au niveau de l'extrémité des fils soudés à la métallisation.

A titre d'exemple, la résine d'enrobage est une résine époxy, la résine d'ancrage / accrochage est une résine cyanoacrylate ou époxy identique ou de nature différente de la première, le corps-support peut être en plastique ; Il peut être en ABS, PVC, ou polycarbonate, PET (Polyéthylène Téréphtalate) ou PEN (Polyéthylène Naphtalate du groupe des polyesters mais plus haute résistance en température que le PET)

## Revendications

1. Procédé de fabrication d'un dispositif électronique (13a, 13b)) comprenant un module (1, 15) fixé dans une cavité d'un corps-support, ledit module comportant un film support (2) ayant une métallisation (3) du côté d'une face supérieure et du côté d'une face inférieure, une puce de circuit intégré (6) reliée à la métallisation à l'aide de fils électriques de raccordement (7, 8), la puce de circuit intégré étant enrobée par une matière d'enrobage et de protection mécanique (9),
**caractérisé en ce qu'**il comprend une étape d'ancrage selon laquelle une seconde matière d'ancrage (11) est prévue pour accrocher une portion (7p, 8p, 17p, 18p) d'au moins un desdits fils électriques et pour ancrer cette portion de fil au corps-support.

2. Procédé selon la revendication précédente, **caractérisé en ce qu'**il comprend une étape d'enrobage de la puce par une première matière d'enrobage (9) à l'exception de ladite portion de fil (7p, 8p, 17p, 18p).

3. Procédé selon la revendication 1, **caractérisé en ce qu'**il comprend une étape d'enrobage de la puce par une première matière d'enrobage (9) et une étape d'enlèvement partiel de matière d'enrobage autour desdites portions (17p, 18p).

4. Procédé selon la revendication précédente, **caractérisé en ce que** l'étape d'enlèvement de matière d'enrobage s'effectue par usinage laser.

5. Procédé selon la revendication 3, **caractérisé en ce que** l'enlèvement de matière d'enrobage forme une rainure (R) rejoignant au moins deux fils électriques et débouchant à la surface de la matière d'enrobage.

6. Procédé selon l'une quelconque des revendications précédentes, **caractérisé en ce qu'**une quantité calibrée de matière d'ancrage (20) est déposée au fond de la cavité avant report du module dans la cavité de manière à faire pénétrer la matière d'ancrage autour de ladite portion de fil lors du report du module dans la cavité.

7. Procédé selon la revendication 5, **caractérisé en ce qu'**une quantité de matière d'ancrage (20) est déposée dans la rainure avant report du module dans la cavité.

8. Procédé selon la revendication 5, **caractérisé en ce que** la matière d'ancrage (20) est déposée sur la surface du module destinée à être encartée et au-dessus de la rainure, sous forme de film thermo-fusible à phase thermodurcissable, avant report du module dans la cavité.

9. Dispositif électronique comprenant un module (1, 15) fixé dans une cavité de corps support, ledit module comportant un film support ayant une métallisation (3) d'un côté d'une face supérieure et du côté d'une face inférieure, une puce de circuit intégré (6) reliée à la métallisation à l'aide de fils électriques de raccordement (7, 8), la puce de circuit intégré étant enrobée au moins partiellement par au moins une matière d'enrobage et de protection mécanique,
**caractérisé en ce que** le dispositif comprend une seconde matière d'ancrage (11, 20) pour enrober une portion d'au moins un fil et pour ancrer cette portion de fil au corps-support (10.

## Patentansprüche

1. Verfahren zur Herstellung einer elektronischen Vorrichtung (13a, 13b) mit einem Modul (1, 15), das im Hohlraum eines Trägerkörpers befestigt ist, wobei besagtes Modul eine Trägerfolie (2) mit einer Metallisierung (3) an einer oberen und einer unteren Fläche und einen IC-Chip (6), welcher über elektronische Anschlussdrähte (7, 8) mit der Metallisierung verbunden ist, aufweist, wobei der IC-Chip mit einem Umhüllungsmaterial und einem mechanischen Schutzmaterial (9) umgeben ist,
**dadurch gekennzeichnet, dass** es aus einem Befestigungsschritt besteht, demzufolge ein Abschnitt (7p, 8p, 17p, 18p) von mindestens einem der elektrischen Drähte mit einem zweiten Befestigungsmaterial am Trägerkörper befestigt werden soll.

2. Verfahren nach dem vorhergehenden Anspruch, **dadurch gekennzeichnet, dass** es einen Schritt umfasst, in dem der Chip mit Ausnahme besagten Drahtabschnitts (7p, 8p, 17p, 18p) mit einem ersten Umhüllungsmaterial (9) umgeben wird.

3. Verfahren nach Anspruch 1, **dadurch gekennzeichnet, dass** es einen Schritt umfasst, in dem der Chip mit einem ersten Umhüllungsmaterial (9) umgeben wird, und einen Schritt, in dem das Umhüllungsmaterial an den besagten Abschnitten (17p, 18p) teilweise entfernt wird.

4. Verfahren nach dem vorhergehenden Anspruch, **dadurch gekennzeichnet, dass** die Entfernung des Umhüllungsmaterials durch Laserbearbeitung erfolgt.

5. Verfahren nach Anspruch 3, **dadurch gekennzeichnet, dass** bei der Entfernung des Umhüllungsmaterials eine Rille (R) entsteht, die zumindest zu zwei elektrische Drähten führt und an der Oberfläche des Umhüllungsmaterials endet.

6. Verfahren nach einem der vorhergehenden Ansprüche, **dadurch gekennzeichnet, dass** eine kalibrierte Menge an Befestigungsmaterial (20) am Boden des Hohlraums aufgetragen wird, bevor das Modul so in den Hohlraum positioniert wird, dass sich das Befestigungsmaterial beim Modultransfer in den Hohlraum um den Drahtabschnitt legt.

7. Verfahren nach Anspruch 5, **dadurch gekennzeichnet, dass** eine bestimmte Menge an Befestigungsmaterial (20) in der Rille aufgetragen wird, bevor das Modul im Hohlraum positioniert wird.

8. Verfahren nach Anspruch 5, **dadurch gekennzeichnet, dass** das Befestigungsmaterial (20) auf der Oberfläche des einzulegenden Moduls in Form einer wärmeschmelzbaren Folie mit wärmehärtbarer Phase oberhalb der Rille aufgetragen wird, bevor das Modul in den Hohlraum positioniert wird.

9. Elektronische Vorrichtung mit einem Modul (1, 15), das im Hohlraum eines Trägerkörpers befestigt ist, wobei besagtes Modul eine Trägerfolie mit einer Metallisierung (3) an einer oberen und einer unteren Fläche umfasst, einen IC-Chip (6), der mit Hilfe von elektrischen Anschlussdrähten (7, 8) mit der Metallisierung verbunden ist, wobei der IC-Chip zumindest teilweise von mindestens einem Umhüllungs- und mechanischen Schutzmaterial umgeben ist,
**dadurch gekennzeichnet, dass** die Vorrichtung ein zweites Befestigungsmaterial (11, 20) umfasst, um einen Abschnitt von mindesten einem Draht zu umhüllen und um diesen Drahtabschnitt am Trägerkörper (10) zu befestigen.

## Claims

1. A method for manufacturing an electronic device (13a, 13b)) comprising a module (1, 15) secured in a cavity of a carrier body, with said module comprising a backing film (2) having a metal coating (3) on an upper face side and on a lower face side, an integrated circuit chip (6) connected to the metal coating using electric connection wires (7, 8), with the integrated circuit chip being coated with a coating and mechanical protective material (9),
**characterized in that** it comprises an anchoring step according to which a second anchoring material (11) is provided for bonding a portion (7p, 8p, 17p, 18p) of at least one of said electric wires and for anchoring said wire portion to the carrier body.

2. A method according to the preceding claim, **characterized in that** it comprises a step of coating the chip using a first coating material (9) except for said wire portion (7p, 8p, 17p, 18p).

3. A method according to claim 1, **characterized in that** it comprises a step of coating the chip using a first coating material (9) and a step of partially removing the coating material around said portions (17p, 18p).

4. A method according to the preceding claim, **characterized in that** the step of removing the coating material is performed by laser machining.

5. A method according to claim 3, **characterized in that** removing the coating material forms a groove (R) joining at least two electric wires and coming out onto the surface of the coating material.

6. A method according to any one of the preceding claims, **characterized in that** a calibrated quantity of the anchoring material (20) is deposited at the bottom of the cavity prior to transferring the module into the cavity so that the anchoring material can penetrate around said wire portion upon transferring the module into the cavity.

7. A method according to claim 5, **characterized in that** a quantity of anchoring material (20) is deposited into the groove module prior to transferring the module into the cavity.

8. A method according to claim 5, **characterized in that** the anchoring material (20) is deposited onto the surface of the module intended to be inserted and above the groove, in the form of a thermoplastic film with a thermosetting phase, prior to transferring the module into the cavity.

9. An electronic device comprising a module (1, 15) secured in a cavity of a carrier body, with said module comprising a backing film having a metal coating (3) on an upper face side and on a lower face side, an integrated circuit chip (6) connected to the metal coating using electric connection wires (7, 8), with the integrated circuit chip being at least partially coated with at least one coating and mechanical protective material (9),
**characterized in that** the device comprises a second anchoring material (11, 20) for coating a portion of at least one wire and for anchoring such wire portion to the carrier body (10).
